# EUROPEAN PATENT APPLICATION

(11) **EP 4 722 749 A1**
(43) Date of publication of application: **08.04.2026**
(21) Application number: 24819298.1
(22) Date of filing: 03.06.2024
(51) Int. Cl.: G01R 33/12, G01R 31/00

(54) **MAGNETIC SATURATION DETECTION DEVICE, PROTECTION SYSTEM, MAGNETIC SATURATION DETECTION METHOD, AND PROTECTION METHOD**

(30) Priority: 05.06.2023 JP 2023092323
(71) Applicant: Nippon Steel Corporation, Tokyo 100-8071 (JP)
(72) Inventor: MIZOKAMI, Masato, Tokyo 100-8071 (JP)
(74) Representative: Vossius & Partner Patentanwälte Rechtsanwälte mbB
(86) International application number: PCT/JP2024/020251
(87) International publication number: WO 2024/253068

(57) **Abstract**

A magnetic saturation detection device derives the strain of an iron core of a current transformer based on the variation in a resistance value of a resistor in a strain gauge. The magnetic saturation detection device determines whether or not the iron core of the current transformer has been magnetically saturated based on the strain of the iron core of the current transformer.

## Description

### TECHNICAL FIELD

The present disclosure relates to a magnetic saturation detection device, a protection system, a magnetic saturation detection method, and a protection method. This application is based upon and claims the benefit of priority of the prior Japanese Patent Application No. 2023-092323, filed on June 5, 2023, the entire contents of which are incorporated herein by reference.

### BACKGROUND ART

In current transformers, an iron core sometimes becomes magnetically saturated during use. As a technique to deal with such magnetic saturation of the iron core, there has been a current transformer with an air gap provided in part of a magnetic path (iron core) (a current transformer with transient characteristics), as described in Patent Literature 1. The technique described in Patent Literature 1 has disclosed using a non-grain-oriented electrical steel strip for an iron core material and reducing the air gap in the magnetic path.

### CITATION LIST

### PATENT LITERATURE

Patent Literature 1: Japanese Laid-open Patent Publication No. 2001-230137

### SUMMARY OF INVENTION

### TECHNICAL PROBLEM

However, the technique described in Patent Literature 1 is a technique for inhibiting the magnetic saturation of an iron core of a current transformer. Therefore, the technique in Patent Literature 1 fails to determine whether or not the iron core of the current transformer has been magnetically saturated. Accordingly, it is not possible to accurately determine whether or not, for example, the value of a secondary current (output current) of the current transformer is a value affected by the magnetic saturation of the iron core. For this reason, there is desired a technique that accurately determines whether or not the iron core of the current transformer has been magnetically saturated.

The present disclosure has been made in consideration of the above problems, and an object thereof is to accurately determine whether or not the iron core of the current transformer has been magnetically saturated.

### SOLUTION TO PROBLEM

The magnetic saturation detection device of the present disclosure is a magnetic saturation detection device that detects magnetic saturation of an iron core of a current transformer, the device including: a first determination means that determines whether or not the iron core has been magnetically saturated based on a measurement result of a strain of the iron core of the current transformer.

The protection system of the present disclosure is a protection system including the magnetic saturation detection device, the system including: a second determination means that determines whether or not there is a possibility of an abnormality in an object, based on at least a secondary current of the current transformer; and a protection means that performs an interruption of a primary current of the current transformer, in which the primary current of the current transformer flows through the object, and the protection means performs the interruption in the case where the first determination means determines that the iron core has not been magnetically saturated and the second determination means determines that there is a possibility of an abnormality in the object, and the protection means does not perform the interruption in cases where either the first determination means determines that the iron core has been magnetically saturated, the second determination means determines that there is no possibility of an abnormality in the object, or both occur.

The magnetic saturation detection method of the present disclosure is a magnetic saturation detection method that detects magnetic saturation of an iron core of a current transformer, the method including: a measurement step that measures a strain of the iron core of the current transformer; and a first determination step that determines whether or not the iron core has been magnetically saturated based on the strain.

The protection method of the present disclosure is a protection method that uses the magnetic saturation detection method, the method including: a second determination step that determines whether or not there is a possibility of an abnormality in an object, based on at least a secondary current of the current transformer; and a protection step that performs an interruption of a primary current of the current transformer, in which the primary current of the current transformer flows through the object, and the protection step performs the interruption in the case where the first determination step determines that the iron core has not been magnetically saturated and the second determination step determines that there is a possibility of an abnormality in the object, and the protection step does not perform the interruption in cases where either the first determination step determines that the iron core has been magnetically saturated, the second determination step determines that there is no possibility of an abnormality in the object, or both occur.

### BRIEF DESCRIPTION OF DRAWINGS

[Fig. 1A] Fig. 1A is a view illustrating an example of a time waveform of a secondary current during a steady state.
[Fig. 1B] Fig. 1B is a view illustrating an example of a variation over time of a transient current and an example of a variation over time of a maximum magnetic flux density.
[Fig. 1C] Fig. 1C is a view illustrating an example of a time waveform of a secondary current during magnetic saturation.
[Fig. 2] Fig. 2 is a diagram illustrating an example of an equivalent circuit of a current transformer.
[Fig. 3] Fig. 3 is a view illustrating examples of time waveforms of a magnetic flux density and a magnetostriction of an iron core material.
[Fig. 4] Fig. 4 is a view illustrating examples of a variation over time of a transient current superimposed on a primary current of the current transformer and a time waveform of a strain occurring in an iron core (iron core strain).
[Fig. 5] Fig. 5 is a diagram illustrating an example of (a part) of an electric power system.
[Fig. 6A] Fig. 6A is a view illustrating a first installation example of a strain gauge.
[Fig. 6B] Fig. 6B is a view illustrating a second installation example of the strain gauge.
[Fig. 7] Fig. 7 is a diagram illustrating an example of a configuration of a magnetic saturation detection device.

### DESCRIPTION OF EMBODIMENTS

Hereinafter, there will be explained an embodiment of the present disclosure with reference to the drawings. Incidentally, the fact that objects to be compared such as lengths, positions, sizes, and intervals, are the same includes the case where they are strictly the same, as well as the case where they are different within a range that does not depart from the gist of the present disclosure (for example, the case where they are different within a tolerance range determined at the time of design).

### (Background and Overview)

First, there are explained the background leading to this embodiment and the overview of this embodiment.

A current transformer is used for the measurement of a current flowing through an object, for example. The object includes at least one of an electric power line and a device, for example. The electric power line and the device may be installed in an electric power system, or may be installed outside the electric power system. Further, the device may be an electric device such as an electric power control device. Further, the object is not limited to the electric power line or the device, as long as it is an object through which a current to be measured by the current transformer flows.

The current transformer includes a secondary winding and an iron core. Incidentally, in the following explanation, the term "iron core" refers to the iron core of the current transformer unless otherwise specified. Further, the primary winding of the current transformer is an electric path (electric wire, or the like) through which the current to be measured flows. In the current transformer, the number of turns of the secondary winding is greater than the number of turns of the primary winding. When the turns ratio of the secondary winding to the primary winding (the number of turns N₁ of the primary winding: the number of turns N₂ of the secondary winding) is 1: 6, a secondary current I₂ becomes 1/6 times a primary current I₁ (I₂ = I₁/6) (where losses in the current transformer are ignored). Incidentally, the primary current and the secondary current are currents flowing through the primary winding and the secondary winding of the current transformer, respectively.

The current transformer is a measuring device, and thus a decrease in measurement accuracy is a problem. As one of the factors that reduces the measurement accuracy of the current transformer, there is magnetic saturation of the iron core. Here, the magnetic saturation in the present disclosure includes a state in which magnetization does not change even when the absolute value of a magnetic field is increased (namely, the relative permeability is about 1). However, the magnetic saturation in the present disclosure is not limited to such a state. For example, a state in which the iron core has been magnetically saturated includes a state in which the relative permeability of the iron core is so small that the current transformation ratio (= I₂/I₁) falls outside a tolerance range for practical use (a state in which the relative permeability approaches 1). The above tolerance range for practical use may be determined, for example, based on the specifications of a device (for example, a relay) that operates based on the secondary current of the current transformer, may also be determined based on the specifications of the current transformer, may also be determined based on the specifications of an object through which the primary current of the current transformer flows, or may also be determined based on at least two of these specifications. Specific examples of the state in which the iron core has been magnetically saturated include a state in which measurements cannot be performed within the range of a class index of the current transformer. Incidentally, the range of the class index is a tolerance range of error relative to a full scale.

Further, this embodiment explains, as an example, the case where the object through which the primary current of the current transformer flows is a transformer, which is an example of the device. Further, this embodiment explains, as an example, the case where the tolerance range for practical use is determined based on the specifications of a device that operates based on the secondary current of the current transformer. More specifically, this embodiment explains, as an example, the case where the tolerance range for practical use is determined based on the operating range of a later-described percentage differential relay 550.

For example, in the case where the transformer connected to the electric power system is protected by a percentage differential relay, an inflow current and an outflow current of the transformer may be measured by the current transformer. Incidentally, the inflow current is current that flows into the transformer (namely, the primary current of the transformer). Further, the outflow current is current that flows out from the transformer (namely, the secondary current of the transformer). In this embodiment, when referred to as the primary current and the secondary current, these currents are assumed to be those of the current transformer, unless it is explicitly stated that they are those of the transformer. Further, in this embodiment, the primary current and the secondary current of the transformer are referred to as the inflow current and the outflow current respectively as necessary. Further, in the following explanation, the object through which the primary current of the current transformer flows is referred to as an object to be protected as necessary.

The percentage differential relay operates in the case where the inflow current and the outflow current are within a preset operating range. Specifically, the percentage differential relay outputs a trip command intended for isolating the transformer from the electric power system. Incidentally, isolation means preventing electric power (current) from being supplied to the object to be protected (the transformer in this embodiment). It is preferable that the fact that no electric power (current) is supplied to the object to be isolated should mean that no electric power (current) is supplied to the object to be protected at all. In this case, the electric power (current) to be supplied to the object to be protected is 0 (zero). However, the fact that no electric power (current) is supplied to the object to be protected is not limited to no electric power (current) being supplied to the object to be protected at all. For example, the fact that no electric power (current) is supplied to the object to be protected may include the fact that the electric power (current) having a magnitude that fails to protect the object to be protected from the current flowing through the electric path (the primary current of the current transformer) is not supplied. In this case, the electric power (current) to be supplied to the object to be protected may exceed 0 (zero).

When the object to be protected is a device, the device is isolated from the electric path through which the primary current of the current transformer flows (an interruption of the primary current to the device is performed). When the object to be protected is an electric power line, a partial section of the electric path through which the primary current of the current transformer flows is isolated from the electric power system (an interruption of the primary current to the section is performed). The operating range of the percentage differential relay (the range of the inflow current and the outflow current that cause the percentage differential relay to operate) is determined based on operating characteristic curves, for example. The operating characteristic curves is a curve intended for determining the condition under which the percentage differential relay operates (the relationship between the inflow current and the outflow current). The operating characteristic curves is determined in the specifications of the percentage differential relay. For example, the operating characteristic curves is represented by a graph on a coordinate system with the horizontal axis representing the inflow current and the vertical axis representing the outflow current. Further, the operating characteristic curves is represented by a graph on a coordinate system with the horizontal axis representing the outflow current and the vertical axis representing the difference current (the inflow current - the outflow current) in some cases. Further, the operating characteristic curves is represented by a graph on a coordinate system with the scalar sum of the inflow current and the outflow current on the horizontal axis and the vector sum of the inflow current and the outflow current on the vertical axis in some cases. Incidentally, the inflow current and the outflow current that determine the operating characteristic curves are converted to the primary side or secondary side. For example, the inflow current that determines the operating characteristic curves is expressed as a value converted to the secondary side.

This embodiment explains, as an example, the case where the inflow current and the outflow current are each measured by the current transformer. Further, assume that there is an error in the secondary current of the current transformer due to magnetic saturation of the iron core, thereby causing the inflow current and the outflow current to fall within the operating range of the percentage differential relay. In this case, the percentage differential relay outputs a trip command even though there is no need to isolate the transformer from the electric power system. That is, the percentage differential relay performs an unnecessary protection operation. Incidentally, isolating the transformer from the electric power system is performed by a switching device, for example.

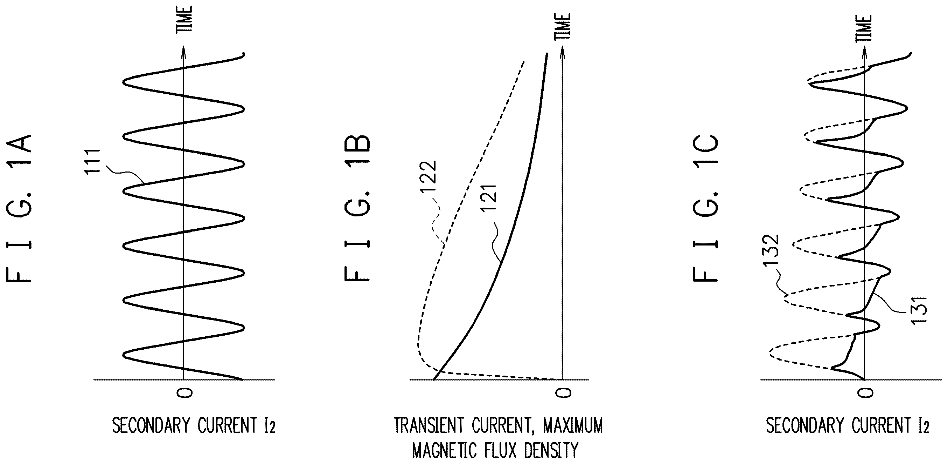

Here, there is explained how the secondary current of the current transformer varies in the case where the iron core becomes magnetically saturated with reference to Fig. 1A to Fig. 1C.

Assume that during a steady state (when not magnetically saturated), a sinusoidal secondary current 111 as illustrated in Fig. 1A flows outside the operating range of the percentage differential relay. When a transient current 121 that decays with a fixed time constant as illustrated in Fig. 1B is superimposed on the primary current I₁ in this state, a maximum magnetic flux density 122 of the iron core increases. When the iron core becomes magnetically saturated due to an increase in the maximum magnetic flux density 122 of the iron core, a time waveform of a secondary current 131 becomes a distorted wave that is a time waveform significantly distorted from a sine wave, as illustrated in Fig. 1C. As illustrated in Fig. 1C, the magnetic saturation of the iron core causes a negative error in the secondary current 131 of the current transformer. Further, a secondary current 132 is a secondary current in the case where the iron core has not been magnetically saturated. The negative error in the secondary current described previously is an error with respect to the secondary current 132.

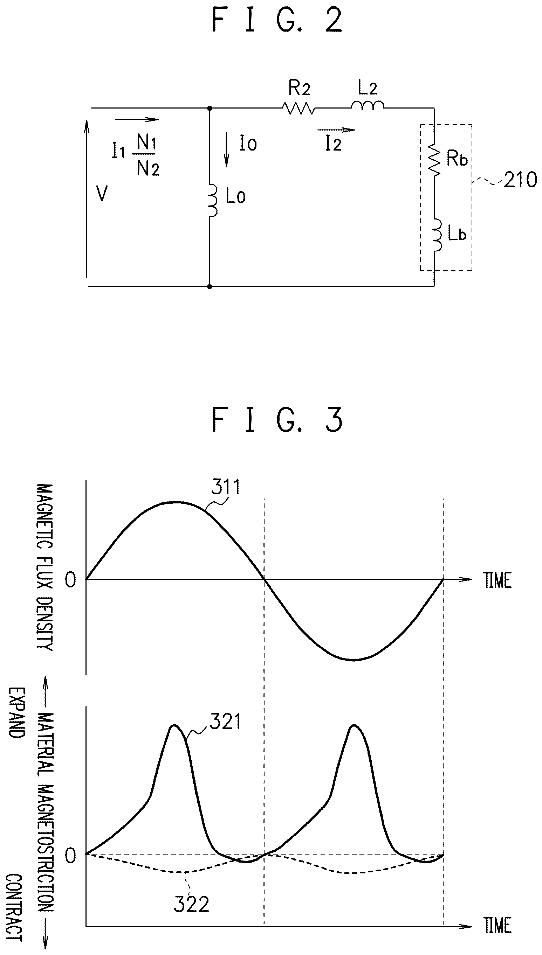

Next, there is explained a mechanism by which the negative error occurs in the secondary current of the current transformer in the case where the iron core becomes magnetically saturated with reference to Fig. 2.

Fig. 2 is a diagram illustrating an example of an equivalent circuit of the current transformer. In Fig. 2, I₀ represents an exciting current. L₀ represents a magnetizing inductance. R₂ represents a direct current resistance of the secondary winding. L₂ represents a leakage inductance on the secondary side. R_{b} represents an internal resistance (direct current resistance) of a burden 210. L_{b} represents an inductance of the burden 210. The burden 210 is a load of the current transformer. The burden 210 is, for example, the percentage differential relay described previously.

In Fig. 2, the magnetizing inductance L₀ during a steady state is sufficiently large. Therefore, the secondary current I₂ is sufficiently larger than the exciting current I₀. The magnetizing inductance L₀ is proportional to the relative permeability of an iron core material. Therefore, when the magnetic flux density of the iron core increases and magnetic saturation occurs as illustrated in Fig. 1B, the relative permeability of the iron core material decreases significantly, and thus, the magnetizing inductance L₀ also decreases significantly. As a result, the exciting current I₀ becomes non-negligibly large relative to the secondary current I₂. Thereby, the time waveform of the secondary current 131 during magnetic saturation, as illustrated in Fig. 1C, is a time waveform in which the time waveform of the secondary current 132 in the magnetically unsaturated state has partially dropped. This partially dropping part becomes the negative error described previously.

As described above, when the iron core becomes magnetically saturated, a negative error occurs in the secondary current. Therefore, in order to cope with the magnetic saturation of the iron core, it is conceivable to use a current transformer with transient characteristics by providing an air gap in the magnetic path (iron core) as described in Patent Literature 1, or to use a non-oriented electrical steel sheet as the iron core material. However, when the above is applied, the magnetizing inductance L₀ during a steady state becomes small, and thus the exciting current I₀ increases. Therefore, in Fig. 2, there is a risk that I₂ may become too small to be ignored in comparison with I₁•N₁/N₂. As a result, there is a risk that the measurement accuracy of the current transformer during a steady state may decrease. In addition, there is a limit to how much the negative error described previously can be reduced by improving the current transformer alone. Incidentally, I₁•N₁/N₂ is the primary current converted to the secondary side.

In contrast, as long as it is possible to determine whether or not the iron core has been magnetically saturated, it is possible to determine whether or not the previously-described negative error is occurring. Therefore, for example, when the negative error is occurring due to the magnetic saturation of the iron core described previously, the percentage differential relay is not allowed to perform a protection operation, thereby making it possible to inhibit the unnecessary protection operation of the percentage differential relay described previously. Therefore, this embodiment explains, as an example, the case where the unnecessary protection operation of the percentage differential relay is inhibited as an application example of determining whether or not the iron core has been magnetically saturated. However, the application example of determining whether or not the iron core has been magnetically saturated is not limited to the inhibition of unnecessary protection operations of the percentage differential relay. For example, the relay for isolating the object to be protected (the transformer in this embodiment) from the electric power system may be a relay other than the percentage differential relay (for example, an overcurrent relay).

Incidentally, the primary current of the current transformer may be an input current of the electric power line and the device, an output current of the electric power line and the device, or a current inside the device. Further, the electric power line and the device may be any type of electric power line and device as long as they exhibit their functions by receiving electric power. The electric power line and the device may be either ones that are distributed as products or ones that are not distributed as products. Further, the result of determination as to whether or not the iron core has been magnetically saturated may be reflected on the display of the secondary current of the current transformer. For example, a display device that displays the value of the secondary current of the current transformer may display information indicating that the iron core has been magnetically saturated, along with the value of the secondary current of the current transformer. Further, the display device that displays the value of the secondary current of the current transformer may display information indicating that the iron core has not been magnetically saturated, along with the value of the secondary current of the current transformer. Further, the display device that displays the value of the secondary current of the current transformer may display information indicating whether or not the iron core has been magnetically saturated, along with the value of the secondary current of the current transformer. Further, when the iron core has been magnetically saturated, the display device that displays the value of the secondary current of the current transformer does not need to display the value of the secondary current of the current transformer. In that case, the display device that displays the value of the secondary current of the current transformer may display information indicating that the iron core has been magnetically saturated. Further, the display of at least one of the information indicating that the iron core has been magnetically saturated and the information indicating that the iron core has not been magnetically saturated may be performed by a display device other than the display device that displays the value of the secondary current of the current transformer. Further, when the information indicating whether or not the iron core has been magnetically saturated is displayed by the display device as described above, it is not necessarily necessary to reflect the result of determination as to whether or not the iron core has been magnetically saturated in the operation of the device (the switching device in this embodiment).

Further, the application example of determining whether or not the iron core has been magnetically saturated is also not limited to the inhibition of unnecessary protection operations of the relay. For example, the current transformer may be connected to an ammeter. The determination as to whether or not the iron core has been magnetically saturated is applied to this example, thereby making it possible to detect that the current value measured by the ammeter is not a correct value due to magnetic saturation of the iron core of the current transformer, for example. In this case, the relay and the switching device may be omitted.

Based on the above background, the present discloser came up with the idea of determining whether or not the iron core has been magnetically saturated. It is also conceivable to perform the detection of magnetic saturation of the iron core based on the voltage or current of the winding. However, these do not directly represent the state of magnetization of the iron core. Thus, the present discloser conceived that it is possible to accurately determine whether or not the iron core has been magnetically saturated by using the strain of the iron core, which changes in response to the state of magnetization of the iron core and changes suddenly as the state of magnetization of the iron core approaches the state of magnetic saturation. The strain here means the variations in dimensions (such as length and width) of the iron core over time.

However, the strain of the iron core is expressed as the value obtained by adding together the strain caused by the change in magnetization of the iron core (magnetostriction) and the strain caused by factors other than the change in magnetization of the iron core. The factors other than the change in magnetization of the iron core include temperature variations in the iron core. Therefore, the present discloser conceived that by using the magnetostriction, which directly represents the state of magnetization of the iron core, among a plurality of types of strains included in the strain of the iron core, whether or not the iron core has been magnetically saturated can be determined with high accuracy. In the following explanation, the strain of the iron core (strain expressed by the value obtained by adding together the previously-described magnetostriction and the strain other than the magnetostriction) is referred to as an iron core strain as necessary. Further, the strain that occurs in the iron core due to the temperature variation in the iron core is referred to as a thermal strain as necessary.

There is explained an example of the magnetostriction that occurs in the iron core in the case where the iron core becomes magnetically saturated below. Fig. 3 is a view illustrating examples of time waveforms of the magnetic flux density and the magnetostriction (material magnetostriction) of the iron core material. The iron core material is a soft magnetic material that forms the iron core. Fig. 3 illustrates, as an example, the case where the iron core material is a grain-oriented electrical steel sheet. Further, Fig. 3 illustrates an example of measuring the magnetostriction, which expands and contracts in the rolling direction in the case where a sample of the grain-oriented electrical steel sheet is excited with an alternating current. The magnetizing direction in the excitation with an alternating current is the rolling direction. Further, the time waveform of the exciting current used during the excitation with an alternating current is a sine wave.

In Fig. 3, a magnetostriction 321 of the iron core material is a magnetostriction in the case where the iron core material is excited with an alternating current so that the magnetic flux density in the iron core material becomes a high magnetic flux density (where the iron core material has been magnetically saturated). Further, a magnetostriction 322 of the iron core material is a magnetostriction in the case where the iron core material is excited with an alternating current so that the magnetic flux density in the iron core material becomes a low magnetic flux density (where the iron core material has not been magnetically saturated). When the iron core material becomes magnetically saturated by exciting the iron core material with an alternating current so that the magnetic flux density in the iron core material becomes a high magnetic flux density, the amplitude of the magnetostriction increases significantly in the elongation direction near the maximum magnetic flux density. That is, as illustrated in Fig. 3, the magnetostriction 321 exhibits a positive peak at a time near the peak of a magnetic flux density 311.

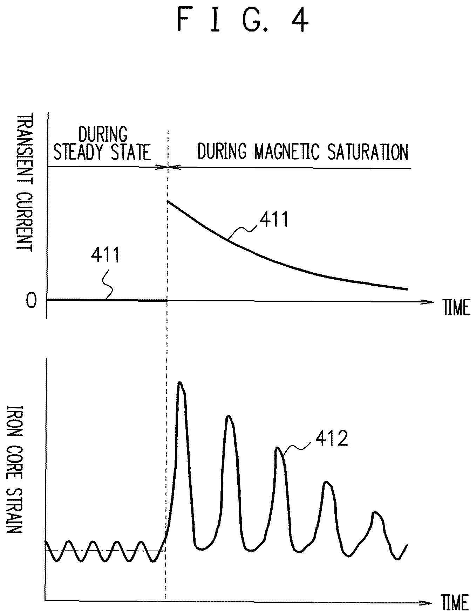

Fig. 4 is a view illustrating examples of a variation over time of the transient current superimposed on the primary current I₁ of the current transformer and a time waveform of the strain occurring in the iron core (iron core strain). During a steady state, a transient current 411 superimposed on the primary current of the current transformer is 0 (zero). In contrast to this, during magnetic saturation, as described previously with reference to Fig. 1B, the transient current 411 that decays with a fixed Lime constant is superimposed on the primary current of the current transformer. During the time when the magnetic field generated in the iron core by this transient current 411 and the magnetic field generated in the iron core by the alternating current flowing as the primary current of the current transformer during a steady state are in the same direction, the magnetic field generated in the iron core becomes extremely large, and thus magnetic saturation occurs. When the magnetic saturation occurs in the iron core as well as in the iron core material, the amplitude of the magnetostriction increases significantly in the elongation direction at a time near the maximum magnetic flux density (see Fig. 3). As described previously, the iron core strain is expressed as the value obtained by adding together the magnetostriction and the strain other than the magnetostriction. Therefore, there is a positive correlation between the iron core strain and the magnetostriction. Thus, as illustrated in Fig. 4, the amplitude of an iron core strain 412 is small during a steady state, but increases in the elongation direction (positive direction) during magnetic saturation. As above, when the iron core becomes magnetically saturated, the amplitude of the iron core strain 412 varies more significantly than when it has not been magnetically saturated. As above, the iron core strain varies significantly depending on whether or not the iron core has been magnetically saturated. Therefore, using the iron core strain makes it possible to reliably determine whether or not the iron core has been magnetically saturated. Further, the variation over time of the thermal strain is slower than the variation over time of the magnetostriction when magnetic saturation occurs. Further, in a general state of use of the current transformer, the stress generated in the iron core by an external force received by the iron core from an object in contact with the iron core of the current transformer is small. Therefore, the strain other than the magnetostriction that occurs when the iron core of the current transformer becomes magnetically saturated may be considered to be the thermal strain mainly. Therefore, when the iron core strain increases suddenly, the cause for the increase can be considered to be magnetostriction. In other words, when the iron core strain increases suddenly, the iron core of the current transformer can be considered to have been magnetically saturated. For this reason, the present discloser conceived that using the magnetostriction of the iron core makes it possible to more reliably determine whether or not the iron core has been magnetically saturated.

As described previously, the iron core strain varies significantly depending on whether or not the iron core has been magnetically saturated. Therefore, whether or not the iron core has been magnetically saturated may be determined based on the result of a comparison between an instantaneous value of the iron core strain at one time (namely, a single instantaneous value of the iron core strain) and a predetermined value.

Further, whether or not the iron core has been magnetically saturated may be determined by using a representative value (for example, an average value) of the iron core strain. In this case, it is possible to inhibit a decrease in the accuracy of determining whether or not the iron core has been magnetically saturated even if the iron core strain is an outlier. For example, as illustrated in Fig. 4, when the iron core becomes magnetically saturated, the average value (arithmetic mean value) of the iron core strain 412 varies. Therefore, whether or not the iron core has been magnetically saturated may be determined based on the result of a comparison between the variation over time of the average value of the iron core strain 412 and a predetermined value, for example. Incidentally, the variation over time of the average value of the iron core strain 412 is expressed, for example, by the difference between an arithmetic mean value of instantaneous values of the iron core strain 412 in a first period and an arithmetic mean value of instantaneous values of the iron core strain 412 in a second period.

However, as described previously, the iron core also expands and contracts due to temperature variations in the iron core. In other words, as described previously, the iron core strain 412 includes the thermal strain in addition to the magnetostriction. Therefore, there is a risk that the average value of the iron core strain 412 may also vary due to the temperature variation in the iron core. Consequently, when whether or not the iron core has been magnetically saturated is determined based on the variation over time of the average value of the iron core strain, there is a risk that the accuracy of determining whether or not the iron core has been magnetically saturated may decrease when the temperature variation in the iron core is large.

Thus, the present discloser investigated a method of calculating the magnetostriction based on the measurement result of the iron core strain. The calculation of the magnetostriction may be performed by using a machine learning model such as a neural network, for example. In this case, for example, the instantaneous values of the iron core strain at a plurality of times may be included in explanatory variables of the machine learning model. However, when the magnetostriction is calculated using the machine learning model, there is a risk that a calculation time and a calculation load may increase. Further, it is necessary to collect a large amount of learning data.

As described previously, the iron core strain varies significantly depending on whether or not the iron core has been magnetically saturated. Further, the factor that causes the iron core strain to vary significantly when the iron core becomes magnetically saturated can be considered to be magnetostriction. Further, in the current transformer, the strain other than the magnetostriction that occurs when the iron core becomes magnetically saturated may be considered to be the thermal strain mainly. Further, as being caused by an accident of a transient current or the like, the magnetic saturation of the iron core occurs instantaneously, whereas the thermal strain occurs due to variations in air temperature or the like, and thus, the variation over time of the thermal strain is small.

Based on the above, the present discloser conceived that it is possible to express the thermal strain by using a representative value of a plurality of instantaneous values of the iron core strain at a plurality of times prior to the time when whether or not the iron core has been magnetically saturated is determined. Then, the present discloser conceived that by calculating the difference between a single instantaneous value (first instantaneous value) of the iron core strain at the time when whether or not the iron core has been magnetically saturated is determined and a representative value of a plurality of instantaneous values (second instantaneous values) of the iron core strain at a plurality of times prior to the time, it is possible to subtract the thermal strain from the iron core strain (namely, to calculate the magnetostriction). The present discloser conceived that by determining whether or not the iron core has been magnetically saturated based on the magnetostriction of the iron core calculated in this manner, it is possible to determine whether or not the iron core has been magnetically saturated with high accuracy.

Incidentally, in the following explanation, the representative value of a plurality of instantaneous values (second instantaneous values) of the iron core strain at a plurality of times prior to the time when whether or not the iron core has been magnetically saturated is determined is referred to as the representative value of the iron core strain as necessary.

Calculating the difference between a single instantaneous value of the iron core strain at the time when whether or not the iron core has been magnetically saturated is determined and the representative value of the iron core strain as the magnetostriction corresponds to performing a calculation intended for subtracting part or all of the strain other than the magnetostriction from the iron core strain. In the following explanation, the instantaneous value is assumed to be a value at one time (namely, a single value) unless otherwise specified that it is values at a plurality of times.

This embodiment explains, as an example, the case where the representative value of the iron core strain to be compared with the instantaneous value of the iron core strain is an average value (arithmetic mean value). However, the representative value is not limited to the average value. The representative value may be the median value, for example. Incidentally, in the following explanation, the representative value of the iron core strain in the case where the representative value of the iron core strain is an average value is referred to as the average value of the iron core strain as necessary. The value obtained by subtracting the average value of the iron core strain from the instantaneous value of the iron core strain expresses the difference between the instantaneous value and the average value of the iron core strain in the positive direction (elongation direction). This embodiment explains, as an example, the case where whether the iron core has been magnetically saturated is determined based on the value obtained by subtracting the average value of the iron core strain from the instantaneous value of the iron core strain. However, this embodiment does not necessarily need to be designed in this manner. For example, whether the iron core has been magnetically saturated may be determined based on the value obtained by subtracting the instantaneous value of the iron core strain from the average value of the iron core strain. In this case, for example, the positive/negative relationship and the magnitude relationship only need to be changed for the case where the value obtained by subtracting the average value of the iron core strain from the instantaneous value of the iron core strain is used. For example, the fact that the value obtained by subtracting the instantaneous value of the iron core strain from the average value of the iron core strain exceeds a predetermined value is replaced by the fact that the value obtained by subtracting the average value of the iron core strain from the instantaneous value of the iron core strain falls below the value obtained by multiplying the predetermined value by -1.

The longer the period for calculating the average value of the iron core strain, the more reliable the average value becomes, but the less frequently the average value is updated. Therefore, the period for calculating the average value of the iron core strain may be determined in advance from such a perspective. For example, the average value of the iron core strain may be calculated in a predetermined period corresponding to a plurality of cycles of the time waveform of the iron core strain. Further, the average value of the iron core strain may be calculated each time the instantaneous value of the iron core strain is obtained. Further, the iron core may be determined to have been magnetically saturated in the case where the value obtained by subtracting the latest average value of the iron core strain from the latest instantaneous value of Lhe iron core strain exceeds a predetermined value (> 0), for example. Further, the iron core may be determined to have not been magnetically saturated in the case where the value obtained by subtracting the latest average value of the iron core strain from the latest instantaneous value of the iron core strain does not exceed the predetermined value (> 0). Incidentally, at least one of the instantaneous value of the iron core strain and the average value of the iron core strain does not need to be the latest value.

In the above case, whether or not the value obtained by subtracting the average value of the iron core strain from the instantaneous value of the iron core strain exceeds the predetermined value (> 0) is an example of a determination condition for determining whether or not the iron core has been magnetically saturated. Whether or not the determination condition is satisfied may be determined each time the instantaneous value of the iron core strain is obtained. Further, whether or not the determination condition is satisfied does not necessarily need to be determined each time the instantaneous value of the iron core strain is obtained. That is, the determination condition may be any condition that makes it possible to determine whether or not the iron core has been magnetically saturated each time the instantaneous value of the iron core strain is obtained. As above, even when the instantaneous value of the iron core strain is obtained, there may be cases where the determination is not made as to whether or not the determination condition is satisfied. For example, this determination condition may be set as a first determination condition. In this case, a second determination condition may further be determined as to whether or not to determine whether or not the first determination condition is satisfied. The second determination condition may be determined based on at least one of the primary current (for example, the amplitude) of the current transformer, the measurement environment of the current transformer, and the state of a device to be connected to the current transformer, for example. Further, the second determination condition may be, for example, a condition that determines whether or not the first determination condition is satisfied in the case where the instantaneous value of the iron core strain is obtained after a predetermined period of time has elapsed since the previous determination as to whether or not the first determination condition is satisfied.

Incidentally, the difference between the time when the instantaneous value of the iron core strain (a single first instantaneous value) is obtained and the final time among the times (a plurality of past times) when a plurality of instantaneous values (a plurality of second instantaneous values) for calculating the average value of the iron core strain are obtained does not need to be excessively large. The time when the instantaneous value of the iron core strain is obtained and the final time among the times when a plurality of instantaneous values for calculating the average value of the iron core strain are obtained may be the same time or different times.

Further, the period for calculating the average value of the iron core strain may be, for example, one cycle rather than a plurality of cycles. Further, the period for calculating the average value of the iron core strain may be adjusted (updated) during actual use.

Further, when the predetermined value, which is compared with the value obtained by subtracting the average value of the iron core strain from the instantaneous value of the iron core strain, is too large, the iron core is easily determined to have not been magnetically saturated even though in fact the iron core has been magnetically saturated. Conversely, when the predetermined value is too small, the iron core is easily determined to have been magnetically saturated even though in fact the iron core has not been magnetically saturated. The predetermined value, which is compared with the value obtained by subtracting the average value of the iron core strain from the instantaneous value of the iron core strain, may be determined in advance from such a perspective. Further, the predetermined value, which is compared with the value obtained by subtracting the average value of the iron core strain from the instantaneous value of the iron core strain, may be adjusted (updated) during actual use. In the following explanation, the predetermined value, which is compared with the value obtained by subtracting the average value of the iron core strain from the instantaneous value of the iron core strain, is referred to as a saturation determination reference value as necessary.

When determining the saturation determination reference value, for example, the iron core strains at a plurality of timings in the case where the magnetic field strength of the iron core is gradually increased from 0 (zero) to magnetically saturate the iron core may be derived. The iron core strains at the plural timings may be derived by performing at least one of an experiment and a numerical simulation, for example. The time waveform of the iron core strain may be derived based on the iron core strains at the plural timings derived as above. In this case, based on the derived time waveform, the value obtained by subtracting the average value of the iron core strain from the instantaneous value of the iron core strain may be derived at least one of the timing at which the iron core can be considered to have been magnetically saturated and the timing at which the iron core can be considered to have not been magnetically saturated. The saturation determination reference value may be determined based on the value obtained by subtracting the average value of the iron core strain from the instantaneous value of the iron core strain derived as above.

It is preferable that the saturation determination reference value should vary depending on the material of the iron core of the current transformer, the operating conditions of the current transformer, and so on. For example, when the ratio of the secondary current to the primary current of the current transformer is 4/6 and the iron core material is high permeability grades described in "JIS C2553: 2019 "Grain-oriented electrical steel strip,"" the absolute value of the saturation determination reference value may be, for example, 0.8 × 10⁻⁶. Further, when the ratio of the secondary current to the primary current of the current transformer is 4/6 and the iron core material is conventional grades described in "JIS C2553: 2019 "Grain-oriented electrical steel strip,"" the absolute value of the saturation determination reference value may be, for example, 1.1 × 10⁻⁶. Instead of 0.8 × 10⁻⁶ and 1.1 × 10⁻⁶, 0.79 × 10⁻⁶, 1.09 × 10⁻⁶, and so on may be used, respectively.

Incidentally, when the value obtained by subtracting the average value of the iron core strain from the instantaneous value of the iron core strain is compared with the saturation determination reference value, the saturation determination reference value is a positive value (0.8 × 10⁻⁶, 1.1 × 10⁻⁶, and so on). On the other hand, when the value obtained by subtracting the sequential value of the iron core strain from the average value of the iron core strain is compared with the saturation determination reference value, the saturation determination reference value is a negative value (-0.8 × 10⁻⁶, -1.1 × 10⁻⁶, and so on).

As described above, the instantaneous value of the iron core strain is used for determining whether or not the iron core has been magnetically saturated, thereby making it possible to detect that the iron core has been magnetically saturated within one cycle from the timing at which the magnetic saturation occurs. Therefore, it is possible to shorten the time lag from when the iron core becomes magnetically saturated actually to when the iron core is determined to have been magnetically saturated (that is, it is possible to perform a determination with excellent responsiveness). Further, for example, when the temperature variation in the iron core is large, it is preferable to calculate the magnetostriction based on the iron core strain. In this case, it is more preferable to calculate the magnetostriction so as to achieve shortening the time lag from when the iron core becomes magnetically saturated actually to when the iron core is determined to have been magnetically saturated and increasing the accuracy of determining whether or not the iron core has been magnetically saturated. Based on the above, this embodiment explains, as an example, the case where whether or not the iron core has been magnetically saturated is determined based on the difference between the instantaneous value and the average value of the iron core strain. However, the determination condition for determining whether or not the iron core has been magnetically saturated is not limited to the condition using the difference between the instantaneous value and the average value of the iron core strain.

As illustrated in Fig. 4, when the iron core becomes magnetically saturated, the instantaneous value of the magnetostriction increases suddenly in the positive direction (elongation direction), and thus the iron core strain also exhibits a variation similar to the variation in the instantaneous value of the magnetostriction. Thus, whether or not the iron core has been magnetically saturated may be determined based on the difference between two instantaneous values of the iron core strain obtained at a fixed time interval, for example. The fixed time may be determined based on, for example, the time from when the iron core begins to be magnetically saturated to when the iron core strain first reaches a peak in the time waveform of the iron core strain.

Further, as described previously, whether or not the iron core has been magnetically saturated may be determined based on the result of a comparison between the instantaneous value of the iron core strain at one time and the predetermined value. Besides, whether or not the iron core has been magnetically saturated may be determined based on the result of a comparison between the variation over time of the representative value (for example, the average value or median value) of instantaneous values of the iron core strain at a plurality of times and the predetermined value. Further, whether or not the iron core has been magnetically saturated may be determined based on the result of a comparison between the instantaneous value of the magnetostriction at one time and the predetermined value. Further, whether or not the iron core has been magnetically saturated may be determined by using the representative value (for example, the average value) of instantaneous values of the magnetostriction at a plurality of times.

### (Magnetic saturation detection device, Protection system, Magnetic saturation detection method, Protection method)

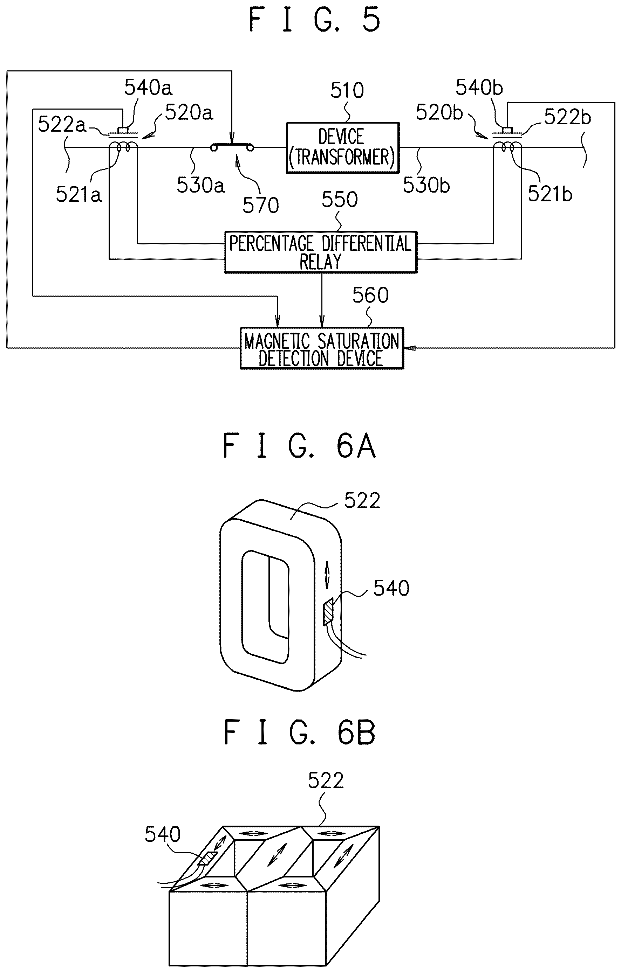

There is explained a specific example of this embodiment in detail below. Fig. 5 is a diagram illustrating an example of the electric power system to which a magnetic saturation detection device and a protection system in this embodiment are applied. Incidentally, Fig. 5 illustrates only a part of the electric power system. Further, as described previously, Fig. 5 illustrates a device (transformer) as an example of an object to be protected.

In Fig. 5, a device 510 is installed in the electric power system. As described previously, this embodiment explains, as an example, the case where the device 510 is a transformer. Incidentally, the transformer may be a single-phase transformer or a three-phase transformer. In the following explanation, the device 510 is referred to as a transformer 510 as necessary.

A current transformer 520a is installed on the primary side (input side) of the transformer 510. The current transformer 520a measures an inflow current (primary current) to the transformer 510. A current transformer 520b is installed on the secondary side (output side) of the transformer 510. The current transformer 520b measures an outflow current (secondary current) from the transformer 510. The current transformers 520a, 520b include secondary windings 521a, 521b and iron cores 522a, 522b respectively. The current transformers 520a, 520b may have the same configuration. The current transformers 520a, 520b may have different configurations. The configurations of the current transformers 520a, 520b are determined based on, for example, the inflow current to and the outflow current from the transformer 510, or another factor. The current transformers 520a, 520b themselves are fabricated by well-known techniques. Therefore, detailed explanations of the current transformers 520a, 520b are omitted. Further, this embodiment explains, as an example, the case where the iron cores 522a, 522b are formed using a grain-oriented electrical steel sheet. However, the iron cores 522a, 522b may be formed using an iron core material other than the grain-oriented electrical steel sheet (for example, a non-oriented electrical steel sheet). Further, air gaps may be provided or do not need to be provided in magnetic paths of the iron cores 522a, 522b. Incidentally, the primary winding of the current transformer 520a is an electric wire 530a that forms the electric path through which the inflow current to the transformer 510 flows. The primary winding of the current transformer 520b is an electric wire 530b that forms the electric path through which the outflow current from the transformer 510 flows.

This embodiment explains, as an example, the case where strain gauges 540a and 540b are attached to the iron cores 522a and 522b respectively. The strain gauges 540a, 540b may have the same configuration. The strain gauges 540a, 540b may have different configurations. The configurations of the strain gauges 540a, 540b are determined based on, for example, the material, size, shape, or the like of the iron cores 522a, 522b of the current transformers 520a, 520b.

For simplicity of explanation, this embodiment explains, as an example, the case where the current transformers 520a, 520b have the same configuration. Similarly, this embodiment explains, as an example, the case where the strain gauges 540a, 540b also have the same configuration. In the following explanation, when there is no need to distinguish between the iron cores 522a and 522b, they are referred to as an iron core 522 as necessary. Similarly, in the following explanation, when there is no need to distinguish between the strain gauges 540a and 540b, they are referred to as a strain gauge 540 as necessary.

Incidentally, in the case where protection by the percentage differential relay is performed, it is common to install each one current transformer on both the input side and the output side of the object to be protected (the transformer 510 in this embodiment). As illustrated in Fig. 5 as an example, the strain gauges 540a and 540b may be attached to both of the iron cores 522a and 522b of the two current transformers 520a and 520b respectively. The strain gauge is attached to the iron core of one of the two current transformers 520a and 520b, which is determined depending on the object to be protected, the configuration of the electric power system, or the like, and does not need to be attached to the iron core of the other current transformer.

Fig. 6A and Fig. 6B are views each illustrating an installation example of the strain gauge 540. In Fig. 6A and Fig. 6B, the double-headed arrow illustrated on the iron core 522 indicates the rolling direction of the grain-oriented electrical steel sheet that forms the iron core 522. Fig. 6A illustrates, as an example, the case where the iron core 522 is a wound iron core. Fig. 6B illustrates, as an example, the case where the iron core 522 is a stacked iron core. Incidentally, for convenience of notation, in Fig. 6A and Fig. 6B, illustration of the line representing the thickness of the grain-oriented electrical steel sheet that forms the iron core 522 is omitted.

In Fig. 6A and Fig. 6B, the strain gauge 540 is preferably bonded to the iron core 522 so that the direction in which strain is detected (the expansion/contraction direction) substantially coincides (preferably coincides) with the rolling direction. The resistance value of a resistor in the strain gauge 540 varies as the iron core 522 expands and contracts in the rolling direction. The strain gauge 540 outputs this variation in the resistance value. The strain gauge 540 itself, and the measurement of strain (iron core strain) using the strain gauge 540 itself, are achieved by well-known techniques. Therefore, detailed explanations of these are omitted.

As above, this embodiment explains, as an example, the case where the sensor for measuring the strain of the iron core 522 (iron core strain) of the current transformer is a strain gauge. However, the sensor for measuring the iron core strain is not limited to the strain gauge. For example, the sensor for measuring the iron core strain may be a sensor (for example, a laser displacement meter) for measuring the strain of the iron core 522 of the current transformer in a non-contact manner.

Further, the sensor for measuring the iron core strain may be, for example, an accelerometer. However, in this case, it is necessary to perform an integral calculation for deriving the iron core strain. Therefore, it is necessary to determine an integral constant. When the iron core has been magnetically saturated, the iron core strain changes transiently. Therefore, it is not easy to accurately estimate the behavior of the integral constant. Therefore, the sensor for measuring the iron core strain is preferably a sensor that measures a physical quantity (specifically, a physical quantity other than acceleration and speed) that enables derivation of the iron core strain without performing the integral calculation.

Further, this embodiment explains, as an example, the case where the iron core strain in the rolling direction is measured. However, the iron core strains in directions other than the rolling direction may be measured. In this case, the direction in which strain is likely to occur in the iron core material may be investigated. For example, the magnitude of strain of the magnetized iron core material may be derived in a plurality of directions. The magnitudes of strains in the plural directions may be derived, for example, by performing at least one of an experiment and a numerical simulation. Based on the magnitudes of the strains in the plural directions derived as above, the direction in which strain is likely to occur in the iron core material may be derived. The iron core strain in the direction derived as above may be measured.

This embodiment explains, as an example, the case where the percentage differential relay 550 determines whether or not the inflow current to and the outflow current from the transformer 510 are within the operating range based on the inflow current to the transformer 510, which is measured in the current transformer 520a, and the outflow current from the transformer 510, which is measured in the current transformer 520b. Further, this embodiment explains, as an example, the case where the percentage differential relay 550 outputs a trip command in the case where the inflow current to and the outflow current from the transformer 510 are within the operating range. Further, this embodiment explains, as an example, the case where the percentage differential relay 550 does not output a trip command in the case where the inflow current to and the outflow current from the transformer 510 are not within the operating range. The percentage differential relay 550 itself is fabricated by a well-known technique. Therefore, a detailed explanation of the percentage differential relay 550 is omitted. However, in general, the trip command to be output from the percentage differential relay 550 is output to a switching device 570. The switching device 570 is a device for isolating the transformer 510 from the electric power system, and is, for example, a circuit breaker. In contrast to this, this embodiment explains, as an example, the case where the percentage differential relay 550 outputs the trip command to a magnetic saturation detection device 560 without outputting it to the switching device 570. In the following explanation, in order to distinguish the trip command to be output from the percentage differential relay 550 from the trip command to be output from the later-described magnetic saturation detection device 560, it is referred to as a temporary trip command as necessary. Incidentally, when the transformer 510 is a three-phase transformer, it is preferable that a current transformer should be provided for each phase, and the percentage differential relay 550 should be provided for each phase.

This embodiment explains, as an example, the case where the magnetic saturation detection device 560 determines whether or not the iron core 522 has been magnetically saturated based on the measurement result of the strain of the iron core 522 (iron core strain). Further, this embodiment explains, as an example, the case where the magnetic saturation detection device 560 is electrically connected to the strain gauge 540 by wire. Further, this embodiment explains, as an example, the case where the magnetic saturation detection device 560 derives the strain of the iron core 522 (iron core strain) based on the variation in the resistance value of the resistor in the strain gauge 540. However, this embodiment does not necessarily need to be designed in this manner. For example, the strain of the iron core 522 (iron core strain) may be derived outside the magnetic saturation detection device 560. Further, this embodiment explains, as an example, the case where the instantaneous value of the iron core strain is handled. Therefore, it is preferable that the measurement system for the iron core strain (coupling of the strain gauge 540 and the magnetic saturation detection device 560, and coupling of respective circuits of the magnetic saturation detection device 560) should be DC coupling. Incidentally, the variation in the resistance value of the resistor and the strain of the iron core 522 (iron core strain) may be input to the magnetic saturation detection device 560 via radio communication.

This embodiment explains, as an example, the case where the magnetic saturation detection device 560 outputs a trip command to the switching device 570 in the case where the temporary trip command has been output from the percentage differential relay 550 and the magnetic saturation detection device 560 determines that the iron core 522 has not been magnetically saturated. Further, this embodiment explains, as an example, the case where the magnetic saturation detection device 560 does not output a trip command to the switching device 570 in at least one of the case where no temporary trip command has been output from the percentage differential relay 550 and the case where the magnetic saturation detection device 560 determines that the iron core 522 has been magnetically saturated. Then, this embodiment explains, as an example, the case where when the switching device 570 acquires the trip command output from the magnetic saturation detection device 560 (rather than the percentage differential relay 550), the switching device 570 isolates the transformer 510 from the electric power system. As above, in this embodiment, when the magnetic saturation detection device 560 determines that the iron core 522 has been magnetically saturated even when the temporary trip command has been output by the percentage differential relay 550 (namely, the percentage differential relay 550 has determined that it is necessary to isolate the transformer 510 from the electric power system), no trip command is output to the switching device 570. Therefore, it is possible to inhibit the unnecessary protection operation described previously in the section of (Background and Overview).

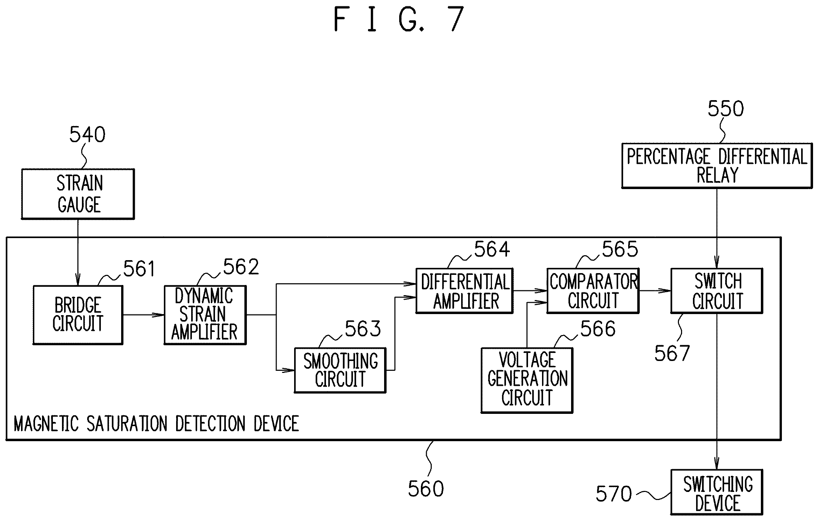

Fig. 7 is a diagram illustrating an example of the configuration of the magnetic saturation detection device 560.

In Fig. 7, this embodiment explains, as an example, the case where the magnetic saturation detection device 560 includes a bridge circuit 561, a dynamic strain amplifier 562, a smoothing circuit 563, a differential amplifier 564, a comparator circuit 565, a voltage generation circuit 566, and a switch circuit 567.

The bridge circuit 561 and the dynamic strain amplifier 562 are examples of the means for deriving the instantaneous value of the iron core strain explained in the section of (Background and Overview). The bridge circuit 561 converts the variation in the resistance value output from the strain gauge 540 into a voltage corresponding to the amount of strain. The dynamic strain amplifier 562 amplifies the output voltage of the bridge circuit 561 and outputs the amplified voltage. This embodiment explains, as an example, the case where the signal to be output from the dynamic strain amplifier 562 is a signal indicating the instantaneous value of the iron core strain, and the signal to be output from the dynamic strain amplifier 562 is a signal indicating a voltage value. The bridge circuit 561 and the dynamic strain amplifier 562 may be well-known ones used in measuring strain.

The smoothing circuit 563 is an example of the means for deriving the average value of the iron core strain explained in the section of (Background and Overview). This embodiment explains, as an example, the case where the smoothing circuit 563 smooths and outputs the signals in a predetermined period corresponding to a plurality of cycles; they are out of the signals indicating the instantaneous value of the iron core strain output from the dynamic strain amplifier 562. This embodiment explains, as an example, the case where the signal to be output from the smoothing circuit 563 is a signal indicating the average value of the iron core strain, and the signal to be output from the smoothing circuit 563 is a signal indicating the voltage value.

The differential amplifier 564 is an example of the means for subtracting the latest average value of the iron core strain from the latest instantaneous value of the iron core strain as explained in the section of (Background and Overview). Subtracting the average value of the iron core strain from the instantaneous value of the iron core strain is an example of calculating the magnetostriction. This embodiment explains, as an example, the case where the differential amplifier 564 amplifies and outputs the difference between the signal indicating the instantaneous value of the iron core strain output from the dynamic strain amplifier 562 and the signal indicating the average value of the iron core strain output from the smoothing circuit 563. As above, this embodiment explains, as an example, the case where the signal to be output from the differential amplifier 564 is a signal indicating the value obtained by subtracting the latest average value of the iron core strain from the latest instantaneous value of the iron core strain, and the signal to be output from the differential amplifier 564 is a signal indicating the voltage value. In the following explanation, the signal to be output from the differential amplifier 564 is referred to as a magnetostrictive differential signal as necessary.

The comparator circuit 565 and the voltage generation circuit 566 are examples of the means for determining whether or not the value obtained by subtracting the latest average value of the iron core strain from the latest instantaneous value of the iron core strain exceeds the saturation determination reference value, as explained in the section of (Background and Overview). The voltage generation circuit 566 is an example of the means for generating a reference voltage corresponding to the saturation determination reference value explained in the section of (Background and Overview). The comparator circuit 565 compares the voltage value indicated by the magnetostrictive differential signal output from the differential amplifier 564 with the reference voltage output from the voltage generation circuit 566. When the former exceeds the latter, the comparator circuit 565 does not outpuL a trip command. Further, when the former does not exceed the latter, the comparator circuit 565 outputs a trip command. This embodiment explains, as an example, the case where the trip command indicates the value of an output voltage of the comparator circuit 565. Further, this embodiment explains, as an example, the case where the fact that the output voltage of the comparator circuit 565 is a value exceeding 0 (zero) corresponds to outputting a trip command. Further, this embodiment explains, as an example, the case where the fact that the output voltage of the comparator circuit 565 is 0 (zero) corresponds to outputting no trip command. In this case, the trip command is a command that indicates the value exceeding 0 (zero) as the value of the output voltage of the comparator circuit 565.

The switch circuit 567 is a circuit connected between an output terminal of the comparator circuit 565 and an input terminal of the switching device 570. This embodiment explains, as an example, the case where the switch circuit 567 electrically connects the output terminal of the comparator circuit 565 to the input terminal of the switching device 570 in the case where a temporary trip command has been output from the percentage differential relay 550 and the magnetic saturation detection device 560 determines that the iron core 522 has not been magnetically saturated. Further, this embodiment explains, as an example, the case where the switch circuit 567 does not electrically connect the output terminal of the comparator circuit 565 to the input terminal of the switching device 570 in the case where a temporary trip command has not been output from the percentage differential relay 550. This embodiment explains, as an example, the case where outputting no trip command to the switching device 570 is achieved by using the switch circuit 567 in the case where a temporary trip command has been output from the percentage differential relay 550 and the magnetic saturation detection device 560 determines that the iron core 522 has been magnetically saturated. Further, this embodiment explains, as an example, the case where outputting a trip command to the switching device 570 is achieved by using the switch circuit 567 in the case where a temporary trip command has been output from the percentage differential relay 550 and the magnetic saturation detection device 560 does not determine that the iron core 522 has been magnetically saturated.

As above, this embodiment explains, as an example, the case where a measurement step is implemented by the operations of the strain gauge 540, the bridge circuit 561, and the dynamic strain amplifier 562. Further, this embodiment explains, as an example, the case where a first determination step and a first determination means are implemented by the operations of the smoothing circuit 563, the differential amplifier 564, the comparator circuit 565, and the voltage generation circuit 566. Further, this embodiment explains, as an example, the case where the fact that the inflow current and the outflow current are within the operating range of the percentage differential relay 550 indicates that there is a possibility of an abnormality in the object (the transformer 510 in this embodiment). Further, this embodiment explains, as an example, the case where a second determination step and a second determination means are implemented by the operation of the percentage differential relay 550 (determining whether or not the inflow current and the outflow current are within the operating range of the percentage differential relay 550). Further, this embodiment explains, as an example, the case where a protection step and a protection means are implemented by the operations of the switch circuit 567 and the switching device 570. Further, this embodiment explains, as an example, the case where a protection system is implemented by using the strain gauge 540, the percentage differential relay 550, the magnetic saturation detection device 560, and the switching device 570. Incidentally, a magnetic saturation detection system may be implemented by using the strain gauge 540 and the magnetic saturation detection device 560. The magnetic saturation detection system may include the percentage differential relay 550 in addition to the strain gauge 540 and the magnetic saturation detection device 560.

Incidentally, as previously described in the section of (Background and Overview), the application example of determining whether or not the iron core has been magnetically saturated is not limited to the inhibition of unnecessary protection operations of the percentage differential relay. For example, determining whether or not the iron core has been magnetically saturated may be applied to inhibiting unnecessary protection operations of the operation of the overcurrent relay. Further, information indicating that the iron core has been magnetically saturated may be displayed on a display device or the like that displays the value of the secondary current of the current transformer. In these cases, for example, the magnetic saturation detection device 560 may include a means (function) for determining that there is a possibility of an abnormality in the object to be protected (the transformer 510 in this embodiment) in the case where the secondary current of the current transformer exceeds a predetermined value. In this case, the magnetic saturation detection device 560 preferably determines that there is a possibility of an abnormality in the object to be protected in the case where the magnetic saturation detection device 560 determines that the iron core has not been magnetically saturated and the secondary current of the current transformer exceeds the predetermined value. Further, the magnetic saturation detection device 560 may determine that there is no possibility of an abnormality in the object to be protected in at least one of the case where the magnetic saturation detection device 560 determines that the iron core has been magnetically saturated and the case where the secondary current of the current transformer does not exceed the predetermined value.

Incidentally, being within the operating range of the percentage differential relay 550 is an example of a condition that is preset as a condition that requires an interruption of the primary current for the object to be protected (the transformer 510 in this embodiment). The condition preset as a condition that requires an interruption of the primary current for the object to be protected (the transformer 510 in this embodiment) is, for example, a condition determined as a condition of breaking the electric path in the specifications of the relay (the percentage differential relay 550 in this embodiment). Generally, the electric path is broken immediately when such a break-condition is satisfied. In contrast to this, this embodiment explains, as an example, the case where the electric path is not broken in the case where the iron core 522 has been magnetically saturated, even if such a break-condition is satisfied.

Further, this embodiment explains, as an example, the case where the magnetic saturation detection device 560 is fabricated by a hardware circuit. However, at least a part of the magnetic saturation detection device 560 may be fabricated by software. In this case, the magnetic saturation detection device 560 may include, for example, one or more hardware processors such as a CPU (Central Processing Unit) and one or more memories such as a RAM (Random Access Memory) and a ROM (Read Only Memory). In this case, the magnetic saturation detection device 560 may execute various calculations by executing one or more programs stored in a memory using one or more hardware processors, for example. The various calculations include calculations for implementing the functions that the smoothing circuit 563, the differential amplifier 564, the comparator circuit 565, and the voltage generation circuit 566 illustrated in Fig. 7 have, for example.

For example, the magnetic saturation detection device 560 may convert the signal indicating the instantaneous value of magnetostriction output from the dynamic strain amplifier 562 into digital data by A/D conversion. In this case, the magnetic saturation detection device 560 may execute the functions that the smoothing circuit 563, the differential amplifier 564, the comparator circuit 565, the voltage generation circuit 566, and the switch circuit 567 have in accordance with software (a computer program). The function that the smoothing circuit 563 has is, for example, a function to execute calculation of the average value of the iron core strain using the instantaneous value of the iron core strain each time the instantaneous value of the iron core strain is obtained. The function that the differential amplifier 564 has is, for example, a function to execute calculation of the value obtained by subtracting the average value of the iron core strain from the instantaneous value of the iron core strain each time the instantaneous value of the iron core strain is obtained. The functions that the comparator circuit 565 and the voltage generation circuit 566 have are, for example, functions to determine whether or not the value obtained by subtracting the average value of the iron core strain from the instantaneous value of the iron core strain exceeds the saturation determination reference value. The function that the switch circuit 567 has is, for example, a function to output a trip command to the switching device 570 only in the case where the temporary trip command has been output from the percentage differential relay 550 and the value obtained by subtracting the average value of the iron core strain from the instantaneous value of the iron core strain does not exceed the saturation determination reference value.

Regarding the function that the switch circuit 567 has, for example, the magnetic saturation detection device 560 may determine whether or not it has acquired a temporary trip command from the percentage differential relay 550 before determining whether or not the value obtained by subtracting the average value of the iron core strain from the instantaneous value of the iron core strain exceeds the saturation determination reference value. In this case, when having acquired the temporary trip command, the magnetic saturation detection device 560 may determine whether or not the value obtained by subtracting the average value of the iron core strain from the instantaneous value of the iron core strain exceeds the saturation determination reference value. Further, when not having acquired the temporary trip command, the magnetic saturation detection device 560 does not need to determine whether or not the value obtained by subtracting the average value of the iron core strain from the instantaneous value of the iron core strain exceeds the saturation determination reference value. In this case, when the magnetic saturation detection device 560 has not acquired the temporary trip command, it is possible to omit the processing in which the magnetic saturation detection device 560 determines whether or not the value obtained by subtracting the average value of the magnetostriction from the instantaneous value of the magnetostriction exceeds the saturation determination reference value.

Further, this embodiment has explained, as an example, the case where the percentage differential relay 550 and the magnetic saturation detection device 560 are different devices. However, for example, the magnetic saturation detection device 560 may have the function that the percentage differential relay 550 has.

Further, the magnetic saturation detection device 560 may be fabricated using dedicated hardware (for example, a FPGA (Field Programmable Gate Array) and an ASIC (Application Specific Integrated Circuit)).

Incidentally, the magnetic saturation detection device 560 illustrated in Fig. 7 may be a device for each of the strain gauges 540a and 540b, for example. In this case, for example, the magnetic saturation detection system may include two magnetic saturation detection devices 560 of the magnetic saturation detection device 560 for the strain gauge 540b. In this case, the temporary trip command may be output in parallel to the switch circuits 567 of the two magnetic saturation detection devices 560 from the percentage differential relay 550. Further, the value of the reference voltage generated by the voltage generation circuit 566 may be a value different for each of the strain gauges 540a and 540b, or may be the same value regardless of the strain gauges 540a, 540b. Further, for example, in Fig. 7, the configuration of all or part of the magnetic saturation detection device 560 may be common to the strain gauges 540a, 540b. In this case, the magnetic saturation detection system may include the single magnetic saturation detection device 560. For example, the switch circuit 567 may be common to the strain gauges 540a, 540b. In this case, the bridge circuit 561, the dynamic strain amplifier 562, the smoothing circuit 563, the differential amplifier 564, the comparator circuit 565, and the voltage generation circuit 566 may be ones for each of the strain gauges 540a and 540b. In this case, the magnetic saturation detection device 560 may include two sets of the bridge circuit 561, the dynamic strain amplifier 562, the smoothing circuit 563, the differential amplifier 564, the comparator circuit 565, and the voltage generation circuit 566. In this case, the switch circuit 567 may individually turn on and off the connection between the output terminal of the comparator circuit 565 and the input terminal of the switching device 570 for the strain gauge 540a, and turn on and off the connection between the output terminal of the comparator circuit 565 and the input terminal of the switching device 570 for the strain gauge 540b. Further, the above may be implemented by software (a computer program) or dedicated hardware. In addition, the resistance value output from only one of the strain gauges 540a and 540b may be input to the magnetic saturation detection device 560 illustrated in Fig. 7.

### (Summary)

As above, in this embodiment, the magnetic saturation detection device 560 derives the strain of the iron core 522 (iron core strain) of the current transformer based on the variation in the resistance value of the resistor of the strain gauge 540. The magnetic saturation detection device 560 determines whether or not the iron core 522 has been magnetically saturated based on the strain of the iron core 522 of the current transformer. Therefore, the iron core strain, which changes suddenly as it approaches magnetic saturation, is used to determine whether or not the iron core 522 has been magnetically saturated, thereby making it possible to determine with high accuracy whether or not the iron core 522 becomes magnetically saturated. Further, it is possible to determine whether or not the iron core 522 has been magnetically saturated without making any major modifications, such as winding a coil around the iron core 522, to the current transformer 520.

Further, in this embodiment, the magnetic saturation detection device 560 determines whether or not the iron core 522 becomes magnetically saturated based on one or more instantaneous values of the iron core strain. The iron core strain is used, thereby making it possible to obtain a highly reliable instantaneous value. Therefore, it is possible to determine with high accuracy whether or not the iron core 522 has been magnetically saturated.

Further, in this embodiment, the magnetic saturation detection device 560 determines whether or not the iron core 522 becomes magnetically saturated by using as a determination condition the condition that makes it possible to determine whether or not the iron core 522 has been magnetically saturated each time a single instantaneous value of the iron core strain is obtained. Therefore, it is possible to reduce the time lag from when the iron core becomes magnetically saturated actually to when the iron core is determined to have been magnetically saturated.

Further, in this embodiment, the magnetic saturation detection device 560 calculates the magnetostriction based on the iron core strain. The magnetic saturation detection device 560 determines whether or not the iron core has been magnetically saturated based on the magnetostriction. Therefore, even when, for example, a thermal strain that is too large to be ignored is included in the iron core strain as a strain other than magnetostriction, it is possible to further inhibit erroneous determination caused by the temperature variation in the iron core 522. Therefore, it is possible to determine with high accuracy whether or not the iron core 522 becomes magnetically saturated.

Further, in this embodiment, the magnetic saturation detection device 560 performs calculation of at least a part of the strain other than magnetostriction of the iron core strain based on the measurement result of the iron core strain, and performs calculation of the magnetostriction based on the measurement result of the iron core strain and the strain other than the magnetostriction. Therefore, it is possible to calculate the magnetostriction without calculating the magnetostriction itself.

Further, in this embodiment, the magnetic saturation detection device 560 determines whether or not the iron core 522 has been magnetically saturated based on a single first instantaneous value of the iron core strain and a representative value of a plurality of second instantaneous values of the iron core strain. Here, a plurality of timings at which the plural second instantaneous values are obtained are timings prior to the timing at which the single first instantaneous value is obtained, and therefore, by using the representative value of the plural second instantaneous values of the iron core strain, the strain other than the magnetostriction can be expressed. Therefore, the strain other than the magnetostriction can be easily calculated.

Further, in this embodiment, the magnetic saturation detection device 560 determines whether or not the iron core 522 has been magnetically saturated based on the difference between the single first instantaneous value of the iron core strain and the representative value of the plural second instantaneous values of the iron core strain. Therefore, the magnetostriction can be expressed by using this difference. Therefore, the magnetostriction can be easily calculated.

Further, in this embodiment, the magnetic saturation detection device 560 determines whether or not the iron core 522 has been magnetically saturated based on the result of a comparison between the difference between the single first instantaneous value of the iron core strain and the representative value of the plural second instantaneous values of the iron core strain and the saturation determination reference value. Therefore, it is possible to easily and highly accurately determine whether or not the iron core 522 has been magnetically saturated.

Further, in this embodiment, the percentage differential relay 550 determines whether or not there is a possibility of an abnormality in the transformer 510 based on at least the secondary current of the current transformer 520. The magnetic saturation detection device 560 operates the switching device 570 in the case where there is a possibility of an abnormality in the transformer 510 and the iron core 522 has not been magnetically saturated. Further, the magnetic saturation detection device 560 does not operate the switching device 570 in at least one of the case where there is no possibility of an abnormality in the transformer 510 and the case where the iron core 522 has been magnetically saturated.

Therefore, in the case where the percentage differential relay 550 determines that there is a possibility of an abnormality in the transformer 510 and the secondary current (output current) of the specific current transformer 520a or 520b is an abnormal value, it is possible to accurately determine whether the cause of the abnormality is due to magnetic saturation of the iron core 522 of the specific current transformer or due to something other than the magnetic saturation of the iron core 522 of the specific current transformer. Then, even when the percentage differential relay 550 determines that there is a possibility of an abnormality in the transformer 510, the magnetic saturation detection device 560 does not operate the switching device 570 when the iron core 522 has been magnetically saturated. Therefore, it is possible to inhibit the unnecessary protection operation of the switching device 570.

### (Other modified examples)

Incidentally, the embodiment of the present disclosure explained above can be implemented by causing a computer to execute a program. Further, a computer-readable recording medium in which the aforementioned program is recorded and a computer program product such as the aforementioned program can also be applied as the embodiment of the present disclosure. As the recording medium, it is possible to use a flexible disk, a hard disk, an optical disk, a magneto-optic disk, a CD-ROM, a magnetic tape, a nonvolatile memory card, a ROM, or the like, for example. Further, the embodiment of the present disclosure may be fabricated by a PLC (Programmable Logic Controller) or by dedicated hardware such as an ASIC (Application Specific Integrated Circuit).

Further, the embodiment of the present disclosure explained above merely illustrates concrete examples of implementing the present disclosure, and the technical scope of the present disclosure is not to be construed in a restrictive manner by the embodiment. That is, the present disclosure may be implemented in various forms without departing from the technical spirit or main features thereof.

### INDUSTRIAL APPLICABILITY

The present disclosure can be utilized for measuring current using a current transformer, for example.

## Claims

1. A magnetic saturation detection device that detects magnetic saturation of an iron core of a current transformer, the device comprising:
a first determination means that determines whether or not the iron core has been magnetically saturated based on a measurement result of a strain of the iron core of the current transformer.

2. The magnetic saturation detection device according to claim 1, wherein
the first determination means determines whether or not the iron core has been magnetically saturated based on one or more instantaneous values of the strain.

3. The magnetic saturation detection device according to claim 2, wherein
a determination condition for determining whether or not the iron core has been magnetically saturated includes a condition that makes it possible to determine whether or not the iron core has been magnetically saturated each time a single instantaneous value of the strain is obtained.

4. The magnetic saturation detection device according to any one of claims 1 to 3, wherein
the first determination means calculates a magnetostriction of the iron core based on a measurement result of the strain, and determines whether or not the iron core has been magnetically saturated based on the magnetostriction.

5. The magnetic saturation detection device according to claim 4, wherein
the first determination means performs calculation of at least a part of the strain of the iron core other than magnetostriction based on a measurement result of the strain, and performs calculation of the magnetostriction based on the measurement result of the strain and at least a part of the strain other than the magnetostriction.

6. The magnetic saturation detection device according to any one of claims 1 to 5, wherein
the first determination means determines whether or not the iron core has been magnetically saturated based on a single first instantaneous value of the strain and a representative value of a plurality of second instantaneous values of the strain, and
a plurality of timings at which the plural second instantaneous values are obtained are timings prior to a timing at which the single first instantaneous value is obtained.

7. The magnetic saturation detection device according to claim 6, wherein
the representative value is an average value.

8. The magnetic saturation detection device according to claim 6 or 7, wherein
the first determination means determines whether or not the iron core has been magnetically saturated based on a difference between the first instantaneous value and the representative value.

9. The magnetic saturation detection device according to claim 8, wherein
the first determination means determines whether or not the iron core has been magnetically saturated based on a result of a comparison between the difference between the first instantaneous value and the representative value and a predetermined value.

10. The magnetic saturation detection device according to any one of claims 1 to 9, wherein
the iron core is formed using a grain-oriented electrical steel sheet, and
the strain is a strain of the grain-oriented electrical steel sheet in a rolling direction.

11. The magnetic saturation detection device according to any one of claims 1 to 10, wherein
the first determination means determines whether or not the iron core has been magnetically saturated based on a strain measured by using a strain gauge.

12. A protection system comprising the magnetic saturation detection device according to any one of claims 1 to 11, the system comprising:
a second determination means that determines whether or not there is a possibility of an abnormality in an object, based on at least a secondary current of the current transformer; and
a protection means that performs an interruption of a primary current of the current transformer, wherein
the primary current of the current transformer flows through the object, and
the protection means performs the interruption in the case where the first determination means determines that the iron core has not been magnetically saturated and the second determination means determines that there is a possibility of an abnormality in the object, and the protection means does not perform the interruption in cases where either the first determination means determines that the iron core has been magnetically saturated, the second determination means determines that there is no possibility of an abnormality in the object, or both occur.

13. The protection system according to claim 12, wherein
the object is a device or an electric power line.

14. A magnetic saturation detection method that detects magnetic saturation of an iron core of a current transformer, the method comprising:
a measurement step that measures a strain of the iron core of the current transformer; and
a first determination step that determines whether or not the iron core has been magnetically saturated based on the strain.

15. A protection method that uses the magnetic saturation detection method according to claim 14, the method comprising:
a second determination step that determines whether or not there is a possibility of an abnormality in an object, based on at least a secondary current of the current transformer; and
a protection step that performs an interruption of a primary current of the current transformer, wherein
the primary current of the current transformer flows through the object, and
the protection step performs the interruption in the case where the first determination step determines that the iron core has not been magnetically saturated and the second determination step determines that there is a possibility of an abnormality in the object, and the protection step does not perform the interruption in cases where either the first determination step determines that the iron core has been magnetically saturated, the second determination step determines that there is no possibility of an abnormality in the object, or both occur.
